(19) Europäisches Patentamt
European Patent Office
Office européen des brevets

(11) **EP 3 340 282 A1**

(12) **DEMANDE DE BREVET EUROPEEN**

(43) Date de publication:
**27.06.2018 Bulletin 2018/26**

(51) Int Cl.:
**H01L 21/20** *(2006.01)*

(21) Numéro de dépôt: **17209131.6**

(22) Date de dépôt: **20.12.2017**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**MA MD TN**

(30) Priorité: **22.12.2016 FR 1663203**

(71) Demandeur: **Commissariat à l'Energie Atomique et aux Energies Alternatives
75015 Paris (FR)**

(72) Inventeurs:
• **GOLANSKI, Luana**
**38610 GIERES (FR)**
• **FOURNEL, Frank**
**38190 VILLARD-BONNOT (FR)**
• **FUGIER, Pascal**
**38190 BERNIN (FR)**
• **RODRIGUEZ, Guillaume**
**38190 LE CHAMP PRES FROGES (FR)**

(74) Mandataire: **Nony
11 rue Saint-Georges
75009 Paris (FR)**

(54) **SUBSTRAT POUR LE DEPOT D'UN FILM DE GRAPHENE**

(57) Substrat utile pour le dépôt d'un film de graphène, le substrat comportant un empilement comportant, en succession et se superposant les uns sur les autres, une base autoporteuse, une couche électriquement isolante et une couche de catalyse, avec la base autoporteuse comportant une zone monocristalline de base,
la couche de catalyse comportant une zone monocristalline de catalyse contenant en masse plus de 99,9% d'un métal de transition choisi parmi le fer, le cobalt, le nickel, le cuivre, le ruthénium, l'iridium, le platine, l'or, le palladium, le rhodium, et leurs alliages,
la couche électriquement isolante comportant une zone monocristalline électriquement isolante contenant en masse plus de 99,9% d'un oxyde présentant une constante diélectrique supérieure à 4,0, et
la zone monocristalline électriquement isolante étant épitaxiée avec la zone monocristalline de catalyse et avec la zone monocristalline de base.

EP 3 340 282 A1

## Description

La présente invention concerne des substrats utiles pour la synthèse par dépôt chimique en phase vapeur de films de graphène et notamment destinés à des applications dans les domaines de la nanoélectronique, des cellules photovoltaïques et des capteurs biologiques.

Pour de telles applications, un film de graphène est généralement disposé sur un support électriquement isolant. Par exemple, à cet effet, il est connu de former un film de graphène par dépôt en voie chimique en phase vapeur sur un substrat massif, par exemple fait de saphir, puis de transférer et coller le film de graphène ainsi formé sur une couche de silice amorphe recouvrant un support de silicium. Il est aussi connu d'obtenir un film de graphène par exfoliation présentant d'excellentes mobilités électriques. Cependant, l'exfoliation de graphène ne permet pas de produire des films de graphène à l'échelle industrielle avec une bonne reproductibilité. Le film est polycristallin et la connexion entre les grains et difficile à contrôler. En outre, les films d'épaisseurs contrôlés et d'une taille supérieure à 100 mm sont difficiles à produire.

Il est par ailleurs décrit dans US 2013/0288464 A1 le dépôt d'un film de graphène par dépôt chimique en phase vapeur (ou « CVD » en anglais, acronyme de Chemical Vapor Deposition) sur une couche métallique disposée sur un substrat comportant une couche de silice amorphe formée en surface d'un support de silicium. Cependant, un film de graphène obtenu par un tel procédé est polycristallin, les grains de graphène étant séparés par des joints de grains à la surface du substrat.

La présence de joints de grains dans le film de graphène polycristallin porte préjudice aux propriétés électriques du film de graphène. Les porteurs de charge diffusent aux joints de grain, ce qui diminue leur mobilité et augmente la résistance électrique du film de graphène. A titre illustratif, la mobilité des porteurs de charge d'un film de graphène polycristallin obtenu par CVD est comprise entre $10^2$ cm$^2$.V$^{-1}$.s$^{-1}$ et $10^3$ cm$^2$.V$^{-1}$.s$^{-1}$ alors qu'elle est supérieure à $10^5$ cm$^2$.V$^{-1}$.s$^{-1}$ pour du graphène exfolié monocristallin disposé sur un support de silicium.

Le développement de joints de grains limite la production de films de graphène homogènes présentant en outre une faible rugosité de surface. A l'heure actuelle, il est par exemple impossible de produire par CVD des films homogènes et continus d'une longueur supérieure à 100 mm. Des techniques de production du graphène par la méthode dite « roll to roll à 30 inch » existent comportant un dépôt de graphène sur un substrat flexible, mais les propriétés de surface du film de graphène obtenues sont inhomogènes et associées à des défauts mécaniques induits pendant le transfert ultérieur sur un substrat rigide.

Pour sa part, l'article « Growth of Wrinkle-Free Graphene on Texture-Controlled Platinum Films and Thermal-Assisted Transfer of Large Scale Patterned Graphene », J.-K. Choi et al., ACS Nano, Vol. 9, No. 1, pages 679-686, 2015, décrit le dépôt d'un film de graphène sur un substrat en platine texturé d'orientation (200) ou (220) disposé sur un support multicouche SiO$_2$/Si, présentant une mobilité des porteurs de charges de 5500 cm$^2$.V$^{-1}$.s$^{-1}$, et une résistance électrique de 200 Ω.sq, ce qui atteste d'une bonne qualité du graphène. Cependant, avec le procédé décrit dans cet article, il n'est pas montré de fabriquer un film de graphène présentant une taille de grains supérieure à 1 mm, inadaptée aux applications précitées.

Il demeure donc un besoin pour un film de graphène, pouvant être fabriqué en quantités industrielles et présentant des propriétés électriques adaptées aux applications visées dans le domaine de la nanoélectronique et des capteurs biologiques.

## Résumé de l'invention

L'invention vise à satisfaire ce besoin en proposant un substrat utile pour le dépôt d'un film de graphène, le substrat comportant un empilement comportant, en succession et se superposant les unes sur les autres, une base autoporteuse, une couche électriquement isolante et une couche de catalyse, avec
la base autoporteuse comportant une zone monocristalline de base,
la couche de catalyse comportant une zone monocristalline de catalyse contenant en masse plus de 99,9% d'un métal de transition choisi parmi le fer, le cobalt, le nickel, le cuivre, le ruthénium, l'iridium, le platine, l'or, le palladium, le rhodium et leurs alliages,
la couche électriquement isolante comportant une zone monocristalline électriquement isolante contenant en masse plus de 99,9% d'un oxyde présentant une constante diélectrique supérieure à 4,0, et
la zone monocristalline électriquement isolante étant épitaxiée avec la zone monocristalline de catalyse et avec la zone monocristalline de base.

Avantageusement, en mettant en oeuvre un procédé de dépôt en phase vapeur d'un précurseur comportant du carbone sur la couche monocristalline de catalyse du substrat selon l'invention, un film de graphène hautement cristallin présentant une rugosité inférieure à 5,0 nm, de préférence inferieure a 1,0 nm, voire de préférence inférieure à 0,3 nm et une taille supérieure ou égale à 1,0 mm, de préférence supérieure ou égale à 5,0 mm, voire de préférence supérieure ou égale à 30,0 mm est formé. La faible teneur, voire l'absence de joints de grains résulte en des propriétés électriques adaptées aux applications de nanoélectronique et des capteurs biologiques. Notamment, le substrat selon l'invention favorise, lors de la croissance du film de graphène au cours du dépôt CVD, la formation d'un grain par coalescence de cristaux formés par croissance de germes présentant des orientations identiques et ayant germés en des zones différentes de la couche de catalyse.

Par ailleurs, la disposition de l'oxyde au sein d'une couche électriquement isolante et disposée sur une base simplifie la fabrication du substrat, par rapport aux substrats connus de l'art antérieur dans lesquels l'oxyde forme un support autoporteur. Le substrat peut ainsi présenter de grandes dimensions, par exemple une longueur et/ou une largeur supérieures à 100 mm, voire supérieures à 200 mm. Comme cela apparaîtra plus clairement par la suite, il est par exemple possible de déposer par dépôt chimique en phase vapeur une couche électriquement isolante de haute qualité cristalline sur une base constituée d'un support monocristallin de silicium de longueur et largeur égales à 200 mm. Un substrat comportant un support autoporteur formé du même oxyde que la couche électriquement isolante et présentant les mêmes longueur et largeur que le substrat selon l'invention, est plus difficile à fabriquer que le substrat selon l'invention. De plus, il ne permet pas de produire un film de graphène de grande qualité cristalline comme en mettant en oeuvre le substrat selon l'invention.

Par ailleurs, l'invention concerne un procédé de fabrication d'un substrat selon l'invention, le procédé de fabrication comportant les étapes successives suivantes consistant à

a) disposer d'une base autoporteuse comportant, voire consistant en, une zone monocristalline de base,

b) former par croissance épitaxiale et au contact de la zone monocristalline de base une zone monocristalline électriquement isolante, et

c) former par croissance épitaxiale, et au contact de la zone monocristalline électriquement isolante, une zone monocristalline de catalyse,

les constituants de la zone monocristalline de base, de la zone monocristalline électriquement isolante, de la zone monocristalline de catalyse étant choisis de manière à former en fin d'étape c) un substrat selon l'invention.

L'invention concerne encore un procédé de production d'un film de graphène, le procédé de production comportant les étapes successives suivantes consistant à :

i) disposer d'un substrat selon l'invention, ou fabriqué ou susceptible d'être fabriqué par le procédé de fabrication selon l'invention, et

ii) former un film de graphène par dépôt épitaxial au contact de la zone monocristalline de catalyse dudit substrat, de préférence au moyen d'un dispositif de dépôt chimique en phase vapeur.

Par ailleurs, l'invention concerne un film de graphène, de préférence produit ou susceptible d'être produit par le procédé de production selon l'invention, ledit film de graphène comportant, voire consistant en, un grain présentant une rugosité inférieure ou égale à 5,0 nm, de préférence inférieure à 1,0 nm, voire de préférence inférieure à 0,3 nm et une taille supérieure ou égale à 1,0 mm, de préférence supérieure ou égale à 5,0 mm, voire de préférence supérieure ou égale à 30,0 mm.

Définitions

Par empilement comportant « en succession » des premier, deuxième et troisième éléments pouvant être des base, support ou couche, il est entendu que les éléments sont empilés les uns sur les autres selon leur ordre de citation. Ainsi, dans le cas de première, deuxième et troisième couches, la deuxième couche est empilée sur la première couche et la troisième couche est empilée sur la deuxième couche. En outre, sauf indication contraire, par défaut, un empilement comportant des premier et deuxième éléments empilés en succession peut comporter un autre élément pouvant être disposé entre les premier et deuxième éléments. L'empilement comporte alors en succession le premier élément, l'autre élément et le deuxième élément.

Par empilement comportant une liste de premier, deuxième et troisième éléments « superposés les uns aux autres », il est entendu que chaque élément de la liste est superposé aux autres éléments de la liste. Autrement dit, le premier élément est superposé au deuxième et au troisième élément, et le deuxième élément est superposé au troisième élément.

Par élément, notamment une base ou un support, « autoporteur », on considère que l'élément présente une rigidité telle qu'il ne peut rompre sous l'effet de son propre poids. Une « couche » nécessite d'être portée et n'est donc pas autoporteuse.

Une « zone monocristalline » est formée d'un matériau cristallin, par exemple un métal ou un oxyde, qui se présente dans ladite zone sous la forme d'un monocristal.

Par l'expression une zone ou une couche « comportant en masse » une teneur exprimée en pourcents d'un constituant, on comprend de manière équivalente que la zone ou la couche respectivement comporte la teneur dudit constituant, exprimée en pourcentages en masse sur la base de la masse de ladite zone ou de la couche respectivement.

Une zone monocristalline « épitaxiée » avec une autre zone monocristalline est obtenue par croissance orientée, du matériau cristallin constituant l'une des zones monocristallines sur le matériau cristallin constituant l'autre zone monocristalline, les dits matériaux cristallins possédant des relations de symétrie cristalline l'un par rapport à l'autre. L'homme du métier sait aisément caractériser et reconnaître deux zones monocristallines épitaxiées l'une avec l'autre.

Lorsqu'une première zone monocristalline constituée d'un premier matériau est épitaxiée avec une deuxième zone monocristalline constituée d'un deuxième matériau, l'homme du métier sait aisément déterminer, d'une part la relation d'épitaxie entre les premier et deuxième matériaux constitutifs respectivement des première et deuxième zones et, d'autre part, dans ladite relation d'épitaxie entre lesdits matériaux, le « désaccord paramétrique » Δ entre lesdits premier et deuxième matériaux. L'article de D.P.Norton, "Synthesis and properties of epitaxial electronic oxide thin film materials," Materials Science and Engineering R, Vol. 43, (2004), pp. 139-247, cite des relations d'épitaxie entre des oxydes cristallins et le silicium.

Le désaccord paramétrique Δ entre le premier matériau et le deuxième matériau est défini selon l'équation de formule (1) suivante :

$$\Delta = \frac{a_1 - a_2}{a_2} \quad (1)$$

dans laquelle $a_1$ et $a_2$ sont des paramètres de maille du premier matériau et du deuxième matériau dans la relation d'épitaxie. A titre illustratif, par exemple le premier matériau est le silicium cristallin et le deuxième matériau est le SrTiO$_3$. SrTiO$_3$ est de structure cristalline cubique et présente un paramètre de la maille cubique $d^{SrTiO_3}_{(100)}$, correspondant au côté de l'arrête de la maille cubique, égal à 3,905 Å. Le silicium cristallin est de structure diamant et présente un paramètre de la maille diamant $d^{Si}_{(100)}$, correspondant au côté de l'arrête de la maille diamant, égal à 5,404 Å. Dans la relation d'épitaxie, un axe (100) de la maille diamant du silicium est parallèle à un axe (100) de la maille cubique de SrTiO$_3$ et un axe (010) du silicium est parallèle à un axe (110) de SrTiO$_3$, la maille cubique de SrTiO$_3$ étant disposée selon une rotation d'un angle de 45° autour de l'axe (100) de la maille diamant du silicium. Le paramètre de maille du silicium dans la relation d'épitaxie $a_{Si}$ est égal à la distance $d^{Si}_{(100)}$ entre deux atomes de silicium selon la direction (100) du silicium et le paramètre de maille de SrTiO$_3$ dans la relation d'épitaxie $a_{SrTiO_3}$ est égal à la distance entre deux atomes de distance $d^{SrTiO_3}_{(110)}$ entre deux atomes de strontium selon la direction (110), avec $d^{SrTiO_3}_{(110)} = \sqrt{2}\, d^{SrTiO_3}_{(100)}$. Ainsi, $a_{SrTiO_3}$ = 5,522 Å et $a_{Si}$ = 5,404 Å. Ainsi dans la relation d'épitaxie entre le silicium cristallin et SrTiO$_3$, le désaccord paramétrique de SrTiO$_3$ avec le silicium cristallin est de 2,2 %.

La « taille » d'un grain ou d'un monocristal est mesurée par microscopie MEB, acronyme de « Microscopie Electronique à Balayage », et par DF-TEM, acronyme anglais de « (Dark Field Transmission Electron Microscopy ».

La « rugosité » d'une couche est mesurée par AFM (acronyme anglais de « Atomic Force Microscopy ») au moyen du dispositif de dénomination commerciale BRUCKER « AFM Dimension 1 ». La mesure de rugosité peut être effectuée au mettant en oeuvre la méthodologie « mode tapping » sur une zone d'analyse X/Y de l'échantillon utilisé, par exemple une couche, un support ou un film, présentant une aire de 1 μm². Le traitement des données acquises sur la zone peut être effectué au moyen du Logiciel « Nanoscope Analysis » version 1.5.

**Figures**

D'autres caractéristiques et avantages de l'invention apparaîtront encore à la lecture de la description détaillée qui va suivre et à la lecture du dessin annexé dans lequel:

- la figure 1 représente un substrat selon un mode de réalisation particulier de l'invention, et
- la figure 2 représente un substrat selon une variante de réalisation de l'invention.

Dans le dessin annexé, les proportions réelles des divers éléments constitutifs ou leurs espacements n'ont pas été toujours été respectées dans un souci de clarté. Par ailleurs, certains éléments peuvent ne pas avoir été représentés en contact les uns avec les autres dans un souci de clarté, alors qu'ils le sont en pratique.

**Description détaillée**

Le substrat 5 comporte un empilement 10 comportant, en succession et se superposant les uns sur les autres, une base 15 autoporteuse, une couche électriquement isolante 20, une couche de catalyse 25, la base autoporteuse comportant une zone monocristalline de base 30.

De préférence, la zone monocristalline de base 30 s'étend selon une surface médiane courbe ou de préférence plane, la longueur et/ou la largeur de la zone monocristalline de base étant supérieure à 50 mm, de préférence supérieure à 100 mm, voire mieux supérieure ou égale à 150 mm.

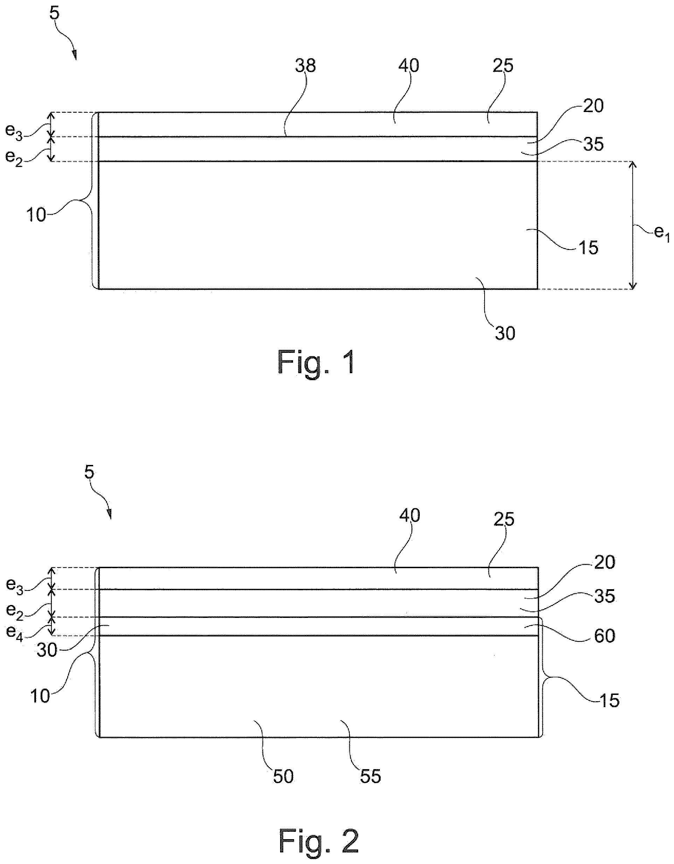

Selon un premier mode de réalisation de l'invention, illustré sur la figure 1, la zone monocristalline de base contient un semi-conducteur cristallin comportant en masse plus de 99,9% de silicium métallique. En particulier, la base peut être monolithique et comporter plus de 99,9% de silicium métallique semi-conducteur. En variante, le semi-conducteur cristallin peut être un matériau de type 3/5, par exemple du GaN.

Selon le premier mode de réalisation, la zone monocristalline de base peut représenter au moins 50%, de préférence au moins 70%, de préférence au moins 90%, de préférence au moins 99%, de préférence au moins 99,9% de la masse de la base. En particulier, comme cela est illustré sur la figure 1, la base peut consister en la zone monocristalline de base. En variante, la base peut comporter une zone polycristalline, par exemple entourant partiellement la zone monocristalline de base. La zone monocristalline de base peut s'étendre sur toute l'épaisseur de la base.

La base peut présenter une forme variée. De préférence, elle se présente sous la forme d'une plaquette présentant deux faces parallèles séparées par l'épaisseur $e_1$ de la base. La plaquette peut notamment présenter une forme de pavé droit et être obtenue, par exemple, par découpe d'un lingot Cz. De préférence, l'axe d'orientation de la zone monocristalline de base est l'axe (001) de la maille diamant du silicium et est sensiblement parallèle à une normale à une face de la plaquette.

De préférence, l'épaisseur de la base $e_1$ est comprise entre 100 $\mu$m et 1000 $\mu$m. De préférence, la longueur de la base est comprise entre 100 mm et 300 mm et/ou la largeur de la base est comprise entre 100 mm et 300 mm.

De préférence, la zone monocristalline de base est orientée selon l'axe (001) étant sensiblement parallèle à une normale à une face de la base, notamment dans le cas où la base est une plaquette, à une face de la plaquette. Par « sensiblement parallèle », on entend que l'angle entre l'axe d'orientation de la zone monocristalline de base et la normale est, en valeur absolue, inférieur à 1°.

La couche électriquement isolante 20 peut recouvrir partiellement, comme cela est illustré sur la figure 1, ou intégralement la base.

De préférence, la couche électriquement isolante est au contact de la base.

De préférence, la couche électriquement isolante est d'épaisseur $e_2$ constante. De préférence, la couche électriquement isolante présente une épaisseur inférieure à 500 nm, de préférence inférieure à 200 nm, voire de préférence inférieure à 150 nm. Avantageusement, et contre toute attente, les inventeurs ont observé que la zone monocristalline de catalyse formée sur une couche électriquement isolante d'une telle faible épaisseur présente un excellent état de surface et permet la croissance d'une couche de graphène selon l'invention.

L'épaisseur de la couche électriquement isolante est de préférence inférieure à 500 nm. Elle présente ainsi une faible rugosité, une bonne qualité cristalline, et un paramètre de maille adapté par rapport à la couche catalytique d'une part et d'autre part par rapport au substrat.

Par ailleurs, la couche électriquement isolante présente de préférence une longueur et/ou une largeur inférieure ou égale à la longueur et/ou la largeur respectivement de la base.

De préférence, la rugosité de la surface de la couche électriquement isolante en contact avec la couche de catalyse est inférieure à 0,3 nm. Ainsi, au cours de la fabrication du substrat, la formation d'une couche de catalyse de haute cristallinité est favorisée.

En ce qui concerne la zone monocristalline électriquement isolante 35, de préférence elle s'étend sur toute l'épaisseur de la couche électriquement isolante.

De préférence, la zone monocristalline électriquement isolante s'étend selon une surface médiane courbe ou de préférence plane, la longueur et/ou la largeur de la zone monocristalline électriquement isolante étant supérieure à 50 mm, de préférence supérieure à 100 mm, voire mieux supérieure ou égale à 150 mm.

De préférence, la zone monocristalline électriquement isolante représente au moins 50%, de préférence au moins 70%, de préférence au moins 90%, de préférence au moins 99%, de préférence au moins 99,9% de la masse de la couche électriquement isolante. De préférence, la couche électriquement isolante consiste en la zone monocristalline électriquement isolante.

La zone monocristalline électriquement isolante est épitaxiée avec la zone monocristalline de base.

De préférence l'oxyde présente un désaccord paramétrique avec le semi-conducteur cristallin, exprimé en valeur absolue, inférieur à 15,0 %. Ainsi, la croissance épitaxiale de la zone monocristalline électriquement isolante sur la zone monocristalline de base est favorisée et la densité de défauts cristallins au sein du volume de la zone monocristalline électriquement isolante est réduite.

De préférence, la zone monocristalline électriquement isolante est prise en sandwich entre la zone monocristalline de catalyse et la zone monocristalline de base.

En particulier, la longueur et/ou la largeur de la zone monocristalline électriquement isolante peuvent être inférieures ou égales à la longueur et/ou à la largeur respectivement de la zone monocristalline de base.

En ce qui concerne le matériau oxyde contenu dans la zone monocristalline électriquement isolante, il présente une constante diélectrique supérieure à 4,0. Un tel oxyde est généralement dénommé « high-K ».

De préférence, l'oxyde est choisi parmi $SrTiO_3$, $MgO$, $GeO_2$, $\alpha$-$Al_2O_3$, $Pr_2O_3$, $\alpha$-$Fe_2O_3$, $TiO_2$, $BaTiO_3$, $CeO_2$, $ZrO_2$, $HfO_2$, $Ta_2O_5$, $SrO$, $BaZrO_3$, $SrZrO_3$, $LaAlO_3$, $YAlO_3$, $PrSeO_3$, $CaO$, $Se_2O_3$, $BaO$, $Lu_2O_3$, $La_2O_3$, $LaScO3$, $GdSc_2O_3$, $Sc_2O_3$, $Y_2O_3$, $SrZrO_3$, $Y_3Al_5O_{12}$, $MgAl_2O_4$ et leurs mélanges, de préférence est choisi parmi $SrTiO_3$, $MgO$, $TiO_2$, $BaTiO_3$, $\alpha$-$Al_2O_3$, $Pr_2O_3$, $\alpha$-$Fe_2O_3$, et leurs mélanges, de préférence est $SrTiO_3$ ou $\alpha$-$Al_2O_3$.

Lorsque l'oxyde présente une symétrie cristalline cubique, la zone monocristalline électriquement isolante peut être orientée selon l'axe (001) de la maille cristalline de l'oxyde, l'axe étant sensiblement parallèle à une normale à une interface 38 entre la zone monocristalline électriquement isolante et la zone monocristalline de catalyse.

Lorsque l'oxyde présente une symétrie cristalline hexagonale, et est notamment choisi parmi $GeO_2$, $\alpha$-$Fe_2O_3$, $Pr_2O_3$, $\alpha$-$Al_2O_3$, la zone monocristalline électriquement isolante peut être orientée selon l'axe (0001) étant l'axe c de la maille hexagonale de l'oxyde, l'axe d'orientation étant sensiblement parallèle à une normale à une interface entre la zone monocristalline électriquement isolante et la zone monocristalline de catalyse.

Par « sensiblement parallèle », on entend que l'angle entre l'axe d'orientation et la normale, en valeur absolue, est inférieur à 1°.

Outre l'oxyde, la zone monocristalline électriquement isolante peut comporter un dopant ou une impureté de l'oxyde, par exemple du platine. De préférence, la concentration massique en dopant et/ou en impureté de la zone monocristalline électriquement isolante est inférieure ou égale à 0,01 %.

En ce qui concerne la couche de catalyse 25, elle peut recouvrir partiellement ou intégralement la couche électriquement isolante 20. De préférence, la couche de catalyse est située à distance de la base 15. Aucun contact n'est de préférence établi entre la couche de catalyse et la base. De préférence, la couche de catalyse est au contact de la couche électriquement isolante.

De préférence, la couche de catalyse est d'épaisseur $e_3$ constante. De préférence, la couche de catalyse présente une épaisseur inférieure à 500 nm. Avantageusement, une couche de catalyse d'une telle épaisseur présente une faible rugosité, une bonne qualité cristalline et un paramètre de maille adapté au film de graphène d'une part et d'autre part à la couche électriquement isolante.

L'épaisseur $e_3$ de la couche de catalyse peut être de 500 nm ou plus. De préférence, la couche présente une rugosité inférieure à 0,3 nm.

Par ailleurs, la couche de catalyse présente de préférence une longueur et/ou une largeur inférieure ou égale à la longueur et/ou la largeur respectivement de la couche électriquement isolante et/ou de la base.

De préférence, la zone monocristalline de catalyse 40 s'étend selon une surface médiane courbe ou de préférence plane, la longueur et/ou la largeur de la zone monocristalline de catalyse étant supérieure à 50 mm, de préférence supérieure à 100 mm, voire mieux supérieure ou égale à 150 mm.

De préférence, le métal de transition présente un désaccord paramétrique avec l'oxyde, exprimé en valeur absolue, inférieur à 15,0 %. De cette façon, la croissance épitaxiale de la zone monocristalline de catalyse sur la zone monocristalline électriquement isolante est favorisée et la densité de défauts cristallins dans la zone monocristalline de catalyse est réduite. En particulier, lorsqu'en outre l'oxyde présente un désaccord paramétrique avec le semi-conducteur cristallin, exprimé en valeur absolue, inférieur à 5,0%, comme décrit précédemment, la qualité cristalline de la couche de catalyse est encore améliorée.

Le métal de transition est choisi parmi le fer (Fe), le cobalt (Co), le nickel (Ni), le cuivre (Cu), le ruthénium (Ru), l'iridium (Ir), le platine (Pt), l'or (Au), le palladium (Pd), le rhodium (Rh), et leurs alliages.

Plus préférentiellement, le métal de transition est choisi parmi le platine, le cuivre, le cobalt, le nickel et leurs alliages.

En particulier le métal de transition peut être un alliage, par exemple un alliage de cuivre et de cobalt, ou un alliage de nickel et de cobalt ou un alliage de nickel et de cuivre.

Notamment, le cuivre, le cobalt et/ou le platine favorisent la production d'un film de graphène monocouche. Le cobalt et le nickel favorisent la production d'un film de graphène multicouche, notamment comportant plus de 1 et moins 6 couches d'épaisseur monoatomique de graphène.

De préférence, le métal de transition est un alliage contenant du platine, de préférence en une teneur d'au moins 50% en masse de l'alliage. Le métal de transition comportant du platine favorise la formation d'un film de graphène de faible rugosité. Cet effet va à l'encontre d'un préjugé selon lequel un film de graphène de haute qualité ne peut être obtenu qu'en diminuant le désaccord paramétrique entre le métal catalyseur et le carbone hexagonal formant le film de graphène. En particulier, l'alliage peut comporter en outre au moins un métal choisi parmi le cobalt, le nickel, et le cuivre. Ainsi, le désaccord paramétrique entre le graphène et le métal de transition est réduit, et un film de graphène de haute qualité cristalline peut être formé par épitaxie sur la couche de catalyse. Des alliages de platine préférés sont un alliage de platine et de cobalt ou un alliage de platine et de cuivre. Dans une variante également préférée, le métal de transition est le platine. Outre le métal de transition, la zone monocristalline de catalyse peut comporter un dopant ou une impureté du métal de transition.

Par ailleurs, la zone monocristalline de catalyse est de préférence orientée :

- selon l'axe (001) ou l'axe (111) lorsque le métal de transition est le platine, ou
- selon l'axe (111) lorsque de métal de transition est le cuivre ou le nickel, ou
- selon l'axe (0002) avec un axe c de structure hexagonale d'orientation (0001) lorsque le métal de transition est le cobalt,

l'axe d'orientation de la zone monocristalline de catalyse étant sensiblement parallèle à une normale à une des faces de la couche de catalyse.

Selon un exemple préféré du premier mode de réalisation de l'invention :

- la base est une plaquette de forme pavé droit présentant deux faces séparées par l'épaisseur de la plaquette, la zone monocristalline de base représente de préférence plus de 99% de la masse de la base, et comporte en masse plus de 99,9% de silicium cristallin, l'axe d'orientation de la zone monocristalline de base est l'axe (001) de la maille diamant du silicium et est sensiblement parallèle à une normale à au moins une des faces de la base,
- la zone monocristalline électriquement isolante représente de préférence plus de 99% de la masse de la couche électriquement isolante, et contient en masse plus de 99,9% de $\alpha$-Al$_2$O$_3$, l'axe d'orientation de la zone monocristalline électriquement isolante est l'axe c (0001) de la maille hexagonale et est sensiblement parallèle à une normale d'au moins une d'une des faces de la base ou à la couche électriquement isolante, et

-  la zone monocristalline de catalyse représente de préférence plus de 99% de la masse de la couche électriquement isolante, et contient en masse plus de 99,9% de platine, l'axe d'orientation de la zone monocristalline de base est l'axe (111) de la maille cubique du platine et est sensiblement parallèle à une normale à au moins une des faces de de la couche de catalyse.

La figure 2 illustre un deuxième mode de réalisation de l'invention. Le substrat 5 du deuxième mode de réalisation diffère du substrat selon le premier mode de réalisation en ce que la base 15 autoporteuse comporte un support 50 autoporteur comportant une zone monocristalline de support 55, et une couche barrière à l'oxygène 60 superposée sur le support, la couche barrière comportant la zone monocristalline de base 30, la zone monocristalline de base étant épitaxiée sur la zone monocristalline de support.

La couche barrière à l'oxygène 60 réduit la migration de l'oxygène entre le matériau constitutif du support, par exemple le silicium cristallin, et l'oxyde, par exemple SrTiO$_3$. De cette façon, on évite la formation à l'interface entre la couche barrière et le support d'une couche formée d'un oxyde amorphe, par exemple de la silice, par oxydation du matériau constitutif du support.

De préférence, la zone monocristalline de support présente une ou plusieurs des caractéristiques de la zone monocristalline de base du premier mode de réalisation de l'invention décrit ci-dessus. Notamment, de préférence, le support comporte plus de 99,9% en masse de silicium cristallin. De préférence, la zone monocristalline de support comporte en masse plus de 99,9% de silicium cristallin. En particulier, le support peut consister en la zone monocristalline de support. En variante, le support peut comporter une zone polycristalline, par exemple entourant partiellement la zone monocristalline de support.

La couche électriquement isolante et/ou la couche de catalyse du substrat présentent une ou plusieurs des caractéristiques que la couche électriquement isolante et la couche de catalyse respectivement du substrat selon le premier mode de réalisation.

De préférence, la couche barrière à l'oxygène est prise en sandwich entre le support et la couche électriquement isolante. De préférence, elle est au contact du support et de la couche électriquement isolante.

De préférence, la couche barrière s'étend selon une surface médiane courbe ou de préférence plane, la longueur et/ou la largeur de la zone monocristalline de base étant supérieure à 50 mm, de préférence supérieure à 100 mm, voire mieux supérieure ou égale à 150 mm.

Selon le deuxième mode de réalisation de l'invention, la couche barrière à l'oxygène comporte la zone monocristalline de base. De préférence, la zone monocristalline de base peut représenter au moins 50%, de préférence au moins 70%, de préférence au moins 90%, de préférence au moins 99%, de préférence au moins 99,9% de la masse de la couche barrière à l'oxygène. En particulier, comme cela est illustré sur la figure 2, la couche barrière à l'oxygène peut consister en la zone monocristalline de base. En variante, la couche barrière à l'oxygène peut comporter une zone polycristalline, par exemple entourant partiellement la zone monocristalline de base.

De préférence, la couche barrière à l'oxygène et/ou la zone monocristalline de base présente une épaisseur $e_4$ comprise entre 5 nm et 500 nm, par exemple égale à 50 nm.

En particulier, la couche barrière à l'oxygène peut présenter une épaisseur inférieure à 100 nm, de préférence inférieure à 70 nm.

En particulier, la zone monocristalline de base peut s'étendre sur toute l'épaisseur de la couche barrière à l'oxygène.

La zone monocristalline de base est épitaxiée sur la zone monocristalline de support.

De préférence, la zone monocristalline de base contient en masse plus de 99,9% d'un matériau, dit « de barrière », de préférence choisi parmi le nitrure de titane TiN, le nitrure d'aluminium AIN, le nitrure de tantale TaN, le nitrure de zirconium ZrN et leurs mélanges, de préférence le nitrure de titane.

De préférence, le matériau de barrière présente un désaccord paramétrique avec le matériau constitutif du support, de préférence avec le silicium cristallin, exprimé en valeur absolue, inférieur à 15,0 %.

De préférence, l'oxyde présente un désaccord paramétrique avec ledit matériau de barrière, en particulier avec TiN, exprimé en valeur absolue, inférieur à 15,0 %.

Selon un exemple préféré du deuxième mode de réalisation de l'invention :

-  le support est une plaquette de forme pavé droit présentant deux faces séparées par l'épaisseur de la plaquette, la zone monocristalline de support représente de préférence plus de 99% de la masse du support et comporte en masse plus de 99,9% de silicium cristallin, l'axe d'orientation de la zone monocristalline de support est l'axe (001) de la maille diamant du silicium et est sensiblement parallèle à une normale à au moins l'une des faces du support,
-  la zone monocristalline de base représente de préférence plus de 99% de la masse de la couche barrière à l'oxygène, et contient en masse plus de 99,9% de nitrure de titane, l'axe d'orientation de la zone monocristalline de base est l'axe (002) de la maille cubique du nitrure de titane et est sensiblement parallèle à une normale à au moins l'une des faces de la couche barrière à l'oxygène,

- la zone monocristalline électriquement isolante représente de préférence plus de 99% de la masse de la couche électriquement isolante et contient en masse plus de 99,9% de SrTiO$_3$, l'axe d'orientation de la zone monocristalline électriquement isolante est l'axe (001) de la maille cubique de SrTiO$_3$ et est sensiblement parallèle à une normale à au moins l'une des faces de la couche électriquement isolante, et
- la zone monocristalline de catalyse représente de préférence plus de 99% de la masse de la couche de catalyse et contient en masse plus de 99,9% de platine, l'axe d'orientation de la zone monocristalline de base est l'axe (001) de la maille cubique du platine et est sensiblement parallèle à une normale à au moins l'une des faces de la couche de catalyse.

Le substrat selon l'invention décrit ci-dessus peut être fabriqué en mettant en oeuvre le procédé de fabrication selon l'invention.

A l'étape a) du procédé de fabrication d'un substrat selon l'invention, on dispose d'une base autoporteuse comportant une zone monocristalline de base.

Selon un premier mode de mise en oeuvre, la zone monocristalline de base est telle que selon le premier mode de réalisation du substrat selon l'invention. De préférence, la base autoporteuse est une plaquette de silicium monocristallin obtenue par découpe d'un lingot Cz. De préférence, selon ledit premier mode de mise en oeuvre, le procédé comporte une étape a$_0$) préalable à l'étape a), consistant à former sur la surface de la zone monocristalline de base destinée à être en contact épitaxial avec la zone monocristalline électriquement isolante, des liaisons hydroxydes OH. Par exemple, à cette fin, on peut mettre en oeuvre une préparation chimique à base d'hydroxyde d'ammonium constitué d'un mélange d'ammoniaque (NH$_4$OH) à 30%, d'eau oxygénée (H$_2$O$_2$) à 30% et d'eau dans les proportion 1-1-5 à une température de 70°C, ou une préparation à base de HF et d'eau diluée dans un rapport 1:10 afin d'enlever la couche d'oxyde de silicium en surface de la zone monocristalline. La croissance épitaxie de l'oxyde de la zone monocristalline de base sur le semi-conducteur cristallin de la base, en particulier le silicium cristallin, est ainsi facilitée.

Selon un deuxième mode de mise en oeuvre, la base autoporteuse est telle que selon le deuxième mode de réalisation du substrat selon l'invention. Elle comporte un support comportant une zone monocristalline de support, le support étant recouvert d'une couche barrière à l'oxygène comportant la zone monocristalline de base. De préférence, selon le dit deuxième mode de mise en oeuvre, le procédé comporte une étape a$_0$') préalable à l'étape a), consistant à former par croissance épitaxiale la zone monocristalline de base sur la zone monocristalline de support. En particulier, à l'étape a$_0$'), on peut former la zone monocristalline de base par dépôt en phase vapeur du matériau de barrière ou d'au moins un précurseur dudit matériau de barrière. De préférence, à l'étape a$_0$'), on dépose du nitrure de titane par dépôt physique en phase vapeur aussi connu sous l'acronyme «PVD» pour Physical Vapor Deposition en anglais, de préférence par dépôt physique en phase vapeur à haute température aussi connu sous l'acronyme « PVD HT » pour Physical Vapor Deposition High Temperature en anglais, sur une plaque de silicium monocristallin obtenue par découpe d'un lingot Cz, de manière à former une couche monocristalline barrière à l'oxygène.

A l'étape b), on forme, par croissance épitaxiale, une zone monocristalline électriquement isolante au contact de la zone monocristalline de base. De préférence, la formation de la zone monocristalline électriquement isolante est effectuée au moyen d'une méthode de dépôt choisie parmi le dépôt chimique en phase vapeur, aussi connu sous l'acronyme «CVD» pour Chemical Vapor Deposition en anglais, notamment le dépôt chimique en phase vapeur aux organométalliques aussi connu sous l'acronyme «MOCVD» pour Metallic Organic Chemical Vapor Deposition en anglais, le dépôt de couches atomiques aussi connu sous l'acronyme «ALD» pour Atomic Layer Deposition en anglais, la pulvérisation, l'évaporation et l'ablation laser. En particulier, on peut former la zone monocristalline électriquement isolante à partir de précurseurs de l'oxyde. En particulier, lorsque l'ALD est mise en oeuvre à partir de précurseurs de l'oxyde pour former la zone monocristalline électriquement isolante, il est préférable que le procédé comporte une étape b'), successive à l'étape b) et préalable à l'étape c), consistant à recuire thermiquement la zone monocristalline thermiquement isolante, de préférence à une température supérieure à 1050 °C, notamment égale à 1100°C. De préférence l'étape b') de recuit thermique est réalisée sous une atmosphère composée d'un mélange d'azote, d'oxygène ou d'air.

A l'étape c), on forme, par croissance épitaxiale, une zone monocristalline de catalyse au contact de la zone monocristalline électriquement isolante. De préférence, à l'étape c), la formation de la zone monocristalline de catalyse est effectuée par PVD, de préférence suivi d'un recuit sous oxygène réactif, ou par MOCVD. De préférence, et notamment dans la variante où l'on dépose du platine pour former la zone monocristalline de catalyse, la pression dans l'enceinte du dispositif de dépôt PVD est inférieure à 20 mTorr. Dans la variante où le métal de transition est le platine ou un alliage de platine et que l'on forme la zone monocristalline de catalyse au moyen d'un dispositif MOCVD, de préférence la température du dit dispositif MOCVD est comprise entre 400°C et 600°C, par exemple égale à 500°C, notamment lorsqu'un précurseur acétylacétonate est mis en oeuvre pour former une zone monocristalline en platine.

De préférence, pour obtenir une couche de catalyse de haute cristallinité, la vitesse de croissance de la zone monocristalline de catalyse est d'environ 1 nm/min. L'homme du métier sait régler les paramètres de dépôt de couche pour obtenir une telle vitesse de croissance. Par exemple, elle est égale à 1,0 nm/min pour un dépôt par dans lequel la puissance de décharge est de 35 W.

Le film de graphène selon l'invention peut être produit au moyen du procédé de production selon l'invention.

Le procédé de production peut notamment comprendre une étape i') intermédiaire aux étapes i) et ii) consistant à nettoyer le substrat, de préférence sous un flux de dihydrogène $H_2$, par exemple pour éliminer les résidus de carbone provenant de précurseurs du métal de transition mis en oeuvre à l'étape c) du procédé de fabrication pour former la zone monocristalline de catalyse.

A l'étape i), de manière à disposer d'un substrat selon l'invention, dans une variante, on peut mettre en oeuvre le procédé de fabrication selon l'invention.

A l'étape ii), on forme un film de graphène par dépôt épitaxial au contact de la zone monocristalline de catalyse du substrat.

De préférence la formation du film de graphène est effectuée par CVD au moyen d'un dispositif de dépôt chimique en phase vapeur.

De préférence, à l'étape ii), le substrat est disposé au sein de l'enceinte du dispositif CVD, et est de préférence chauffé à une température comprise entre 500 °C et 1100°C, par exemple égale à 800°C. De préférence, la formation du film de graphène résulte de la décomposition catalytique d'un gaz carboné, de préférence d'un alcane, plus préférentiellement de méthane $CH_4$, ou de propylène, d'acétylène, de benzène ou de pyridine, en présence d'un catalyseur métallique, par exemple comportant voire constitué de platine, de cuivre, de nickel et/ou de cobalt. De préférence, à l'étape ii), un mélange de méthane et de dihydrogène est injecté dans l'enceinte. De préférence, le rapport du débit massique de méthane sur le débit massique 5 slm (standard litre par minute) de dihydrogène est inférieur ou égal à 1/100, de préférence inférieur ou égal à 1/1000. La densité de nucléation de germes de graphène en surface de la zone monocristalline de catalyse est ainsi réduite, limitant le nombre de grains dans le film de graphène.

Le procédé de production peut en outre comprendre une étape iii), successive à l'étape ii) au cours duquel le substrat recouvert du film de graphène est refroidi jusqu'à ce que la température du substrat recouvert du film de graphène soit inférieur à 30°C. De préférence, à l'étape iii), le refroidissement est effectué sous un flux gazeux de di-hydrogène. En particulier, la température de refroidissement peut être inférieure 1,0 °C.s⁻¹.

De plus, le procédé de production peut comporter une étape iv), successive à l'étape ii) et le cas échéant à l'étape iii), consistant à décoller le film de graphène du substrat, puis à recouvrir un support récepteur dudit film de graphène.

## Exemples

L'invention est maintenant illustrée au moyen des exemples non limitatifs décrits ci-dessous.

### Exemple 1

Une plaquette de silicium est découpée d'un lingot Cz. La plaquette est monocristalline et présente une orientation (001) perpendiculaire aux faces de la plaquette séparées par l'épaisseur. Elle présente un diamètre de 200 mm et une épaisseur de 725 $\mu$m.

Un traitement de surface est réalisé sur une face de la plaquette. On met en oeuvre une préparation chimique à base d'hydroxyde d'ammonium constitué d'un mélange d'ammoniaque ($NH_4OH$) à 30%, d'eau oxygénée ($H_2O_2$) à 30% et d'eau dans les proportion 1-1-5 à une température de 70°C. Ensuite une préparation à base de HF et d'eau diluée dans un rapport 1:10 afin d'enlever l'oxyde de silicium natif de la plaquette.

La plaquette est disposée dans l'enceinte d'un dispositif PVD HT et une couche monocristalline de nitrure de titane TiN d'épaisseur 50 nm est formée par épitaxie en surface de la plaquette monocristalline de silicium. L'orientation de la couche TiN est (002), l'axe d'orientation étant perpendiculaire aux faces de la plaquette de silicium.

La plaquette recouverte de la couche de nitrure de titane est extraite de l'enceinte du dispositif PVD HT (acronyme anglais de « Physical Vapour Deposition High Temperature ») puis est introduite dans l'enceinte d'un dispositif MOCVD PVD (pour former une couche monocristalline électriquement isolante constituée de $SrTiO_3$ epitaxiée sur la couche monocristalline de nitrure de titane. Le dépôt de $SrTiO_3$ est effectué sous une pression inférieure à 20 mTorr à une température comprise entre 500°C et 800°C et avec une puissance de décharge de 35 W. La couche monocristalline de $SrTiO_3$ ainsi obtenue est orientée selon l'axe (001), l'axe d'orientation étant perpendiculaire aux faces de la plaquette de silicium, et présente une épaisseur de 100 nm. Par ailleurs, la rugosité de surface de la couche de $SrTiO_3$ est inférieure à 1,0 nm.

La plaquette recouverte des couches TiN et $SrTiO_3$ est extraite de l'enceinte du dispositif PVD et est introduite dans l'enceinte d'un dispositif PVD HT au sein de laquelle une couche monocristalline de platine d'épaisseur inférieure à 500 nm est formée. Un recuit thermique à haute température pour améliorer la cristallinité du métal peux être effectuée. Le substrat est ensuite nettoyé au moyen d'un flux de plasma sous dihydrogène puis est disposé dans l'enceinte d'un dispositif de dépôt CVD. Il est chauffé à 800°C sous une atmosphère de dihydrogène. Un flux de méthane est injecté dans l'enceinte et un film de graphène est formé et est épitaxié sur la couche de catalyse du substrat par décomposition catalytique du méthane. Le rapport du débit massique de méthane sur le débit volumique massique de dihydrogène est fixé à 1/1000. La durée du dépôt est de 2h. Le substrat recouvert du film est ensuite refroidi sous atmosphère de dihydrogène jusqu'à T = 600°C. Il est ensuite refroidi puis sorti du dispositif à la température ambiante.

Le film de graphène ainsi obtenu comporte un grain présentant une taille de 1 mm, une épaisseur comprise entre 0,2 et 1,0 nm et une rugosité moyenne de surface inférieure à 3,0 nm. La résistance carre du film de graphène, mesurée par la méthode des quatre pointes est inférieure à 350 Ohm/square et la mobilité des porteurs de charges, mesurée par effet Hall inferieure à $5x10^4 cm^2/Vs$.

Exemple 2

Une plaquette de silicium est découpée d'un lingot Cz. La plaquette est monocristalline et présente une orientation (001) perpendiculaire aux faces de la plaquette séparées par l'épaisseur. Elle présente un diamètre de 200 mm et une épaisseur de 725 $\mu$m.

Un traitement de surface est réalisé sur une face de la plaquette. A cet effet, on met en oeuvre une préparation chimique à base d'hydroxyde d'ammonium constitué d'un mélange d'ammoniaque ($NH_4OH$) à 30%, d'eau oxygénée ($H_2O_2$) à 30% et d'eau dans les proportion 1-1-5 à une température de 70°C, ou une préparation à base de HF et d'eau diluée dans un rapport 1:10 afin d'enlever la couche d'oxyde de silicium en surface de la plaquette.

La plaquette est disposée dans l'enceinte d'un dispositif ALD. La plaquette est chauffée à une température de 350°C et une couche d'alumine amorphe d'épaisseur inférieure à 20 nm est formée en surface de face de la plaquette monocristalline de silicium comportant des liaisons hydroxydes. La couche d'alumine est formée dans l'enceinte du dispositif ALD à partir de précurseurs triméthylaluminium et $H_2O$.

L'empilement formé de la plaquette d'alumine recouverte de la couche d'alumine est extraite du dispositif ALD, puis recuite dans un four à une température de 1100°C sous une atmosphère constituée d'un mélange de $N_2$ et $O_2$, de façon à ce que l'alumine cristallise sous la forme hexagonale d'un cristal de saphir $\alpha$-$Al_2O_3$ et soit épitaxiée sur le silicium de la plaquette. L'orientation de la couche de saphir est (0001) correspondant à l'axe c de la structure cristalline hexagonale, l'axe d'orientation étant perpendiculaire aux faces de la plaquette de silicium.

La plaquette recouverte de la couche de saphir est extraite du four puis est introduite dans l'enceinte d'un dispositif PVD HT basse pression. La température de dépôt est fixée à environ 450°C et la pression dans l'enceinte du dispositif est au plus de $10^{-3}$ mbar. Une couche monocristalline de platine d'épaisseur inférieure à 500nm et de rugosité inférieure à 3 nm est formée et est épitaxie sur la couche de saphir. Un recuit thermique à haute température pour améliorer la cristallinité du platine est effectué.

Le substrat est ensuite nettoyé au moyen d'un flux de dihydrogène puis est disposé dans l'enceinte d'un dispositif de dépôt CVD. Le substrat est chauffé à 800°C sous une atmosphère de dihydrogène. Un flux de méthane est injecté dans l'enceinte et un film de graphène est formé par épitaxie sur la couche de catalyse du substrat par décomposition catalytique du méthane. Le rapport du débit volumique de méthane sur le débit volumique de dihydrogène est fixé à 1/1000. La durée du dépôt est de 2h. Le substrat recouvert du film est ensuite refroidi sous atmosphère de dihydrogène jusqu'à température ambiante.

Le film de graphène ainsi obtenu comporte un grain présentant une taille supérieur à 1,0 mm, une épaisseur de 0,2 nm à 1,0 nm et une rugosité de surface inférieure à 3 nm. La résistance carré du film de graphène, mesurée par la méthode des quatre pointes est inferieure à 350 Ohm/carre et la mobilité des porteurs de charges, mesurée par effet Hall est de $5x10^4 cm^2/Vs$.

Bien évidemment, l'invention n'est pas limitée aux modes de réalisation du substrat ni aux modes de mise en oeuvre du procédé de fabrication et du procédé de production qui y sont décrits.

**Revendications**

1. Substrat (5) utile pour le dépôt d'un film de graphène, le substrat comportant un empilement (10) comportant, en succession et se superposant les uns sur les autres, une base autoporteuse (15), une couche électriquement isolante (20) et une couche de catalyse (25), avec

   la base autoporteuse comportant une zone monocristalline de base,

   la couche de catalyse comportant une zone monocristalline de catalyse (40) contenant en masse plus de 99,9% d'un métal de transition choisi parmi le fer, le cobalt, le nickel, le cuivre, le ruthénium, l'iridium, le platine, l'or, le palladium, le rhodium, et leurs alliages, la couche électriquement isolante comportant une zone monocristalline électriquement isolante (35) contenant en masse plus de 99,9% d'un oxyde présentant une constante diélectrique supérieure à 4,0, et

   la zone monocristalline électriquement isolante étant épitaxiée avec la zone monocristalline de catalyse et avec la zone monocristalline de base.

2. Substrat selon la revendication 1, dans laquelle la zone monocristalline de base contient en masse plus de 99,9% de silicium métallique semi-conducteur.

3. Substrat selon la revendication 1, dans laquelle la base autoporteuse comporte un support (50) autoporteur comportant une zone monocristalline de support (55), et une couche barrière à l'oxygène (60)

superposée sur le support, la couche barrière comportant la zone monocristalline de base, la zone monocristalline de base étant épitaxie avec la zone monocristalline de support.

4. Substrat selon la revendication 3, dans laquelle la zone monocristalline de support contient en masse plus de 99,9% de silicium métallique.

5. Substrat selon l'une quelconque des revendications 1 à 4, dans lequel l'oxyde présente un désaccord paramétrique avec le dit métal de transition compris, en valeur absolue, inférieur à 15,0%.

6. Substrat selon l'une quelconque des revendications 1 à 5, dans lequel la couche électriquement isolante présente une épaisseur inférieure à 500 nm, de préférence inférieure à 200 nm, voire de préférence inférieure à 150 nm.

7. Substrat selon l'une quelconque des revendications 1 à 6, dans lequel l'oxyde cristallin est choisi parmi $SrTiO_3$, $MgO$, $GeO_2$, $\alpha$-$Al_2O_3$, $Pr_2O_3$, $\alpha$-$Fe_2O_3$, $TiO_2$, $BaTiO_3$, $CeO_2$, $ZrO_2$, $HfO_2$, $Ta_2O_5$, $SrO$, $BaZrO_3$, $SrZrO_3$, $LaAlO_3$, $YAlO_3$, $PrSeO_3$, $CaO$, $Se_2O_3$, $BaO$, $Lu_2O_3$, $La_2O_3$, $LaScO3$, $GdSc_2O_3$, $Sc_2O_3$, $Y_2O_3$, $SrZrO_3$, $Y_3Al_5O_{12}$, $MgAl_2O_4$ et leurs mélanges.

8. Substrat selon l'une quelconque des revendications 1 à 7, dans lequel la couche de catalyse présente une épaisseur inférieure ou égale à 500 nm.

9. Substrat selon l'une quelconque des revendications 1 à 8, dans lequel le métal de transition est choisi parmi le cobalt, le nickel, le cuivre, le platine et leurs alliages, en particulier est un alliage contenant du platine.

10. Substrat selon la revendication 9, dans lequel le métal de transition est le platine.

11. Substrat selon l'une quelconque des revendications 1 à 10, dans lequel la zone monocristalline de base est orientée selon l'axe (001) et la zone monocristalline de catalyse est orientée :

   - selon l'axe (001) ou l'axe (111) lorsque le métal de transition est le platine, ou
   - selon l'axe (111) lorsque de métal de transition est le cuivre ou le nickel, ou
   - selon l'axe (0002) un axe c de structure hexagonale d'orientation (0001) lorsque le métal de transition est le cobalt,

   l'axe d'orientation étant parallèle à une normale à une des faces de la couche de catalyse.

12. Substrat selon quelconque des revendications 3 à 11, dans lequel la zone monocristalline barrière à l'oxygène comporte en masse plus de 99,9% d'un matériau choisi parmi le nitrure de titane TiN, le nitrure d'aluminium AIN, le nitrure de tantale TaN, le nitrure de zirconium ZrN, de préférence de nitrure de titane.

13. Substrat selon l'une quelconque des revendications 3 à 12, dans lequel la couche barrière à l'oxygène présente une épaisseur inférieure à 100 nm, de préférence inférieure à 70 nm.

14. Procédé de fabrication d'un substrat selon l'une quelconque des revendications précédentes, le procédé comportant les étapes successives suivantes consistant à :

   a) disposer d'une base autoporteuse comportant, voire consistant en, une zone monocristalline de base,
   b) former par croissance épitaxiale et au contact de la zone monocristalline de base une zone monocristalline électriquement isolante, et
   c) former par croissance épitaxiale, et au contact de la zone monocristalline électriquement isolante, une zone monocristalline de catalyse,

   les constituants de la zone monocristalline de base, de la zone monocristalline électriquement isolante, de la zone monocristalline de catalyse étant choisis de manière à former en fin d'étape c) un substrat selon l'une quelconque des revendications précédentes.

15. Procédé de production d'un film de graphène, le procédé de production comportant les étapes successives suivantes consistant à :

   i) disposer d'un substrat selon l'une quelconque des revendications 1 à 13, ou fabriqué ou susceptible d'être fabriqué par le procédé de fabrication selon la revendication 14, et
   ii) former un film de graphène par dépôt épitaxial au contact de la zone monocristalline de catalyse dudit substrat, de préférence au moyen d'un dispositif de dépôt chimique en phase vapeur.

Fig. 1

Fig. 2

Europäisches
Patentamt

European
Patent Office

Office européen
des brevets

**RAPPORT DE RECHERCHE EUROPEENNE**

Numéro de la demande

EP 17 20 9131

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2007/084398 A1 (SCHRECK MATTHIAS [DE] ET AL) 19 avril 2007 (2007-04-19) | 1-15 | INV. H01L21/20 |
| Y | * alinéas [0007] - [0010], [0024] - [0030]; exemples * ----- | 15 | |
| Y | US 2016/108546 A1 (PARK HO BUM [KR] ET AL) 21 avril 2016 (2016-04-21) * revendications * ----- | 15 | |

**DOMAINES TECHNIQUES RECHERCHES (IPC)**

H01L

Le présent rapport a été établi pour toutes les revendications

| Lieu de la recherche | Date d'achèvement de la recherche | Examinateur |
|---|---|---|
| Munich | 7 mai 2018 | Wolff, Gerhard |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

........................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 17 20 9131

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

07-05-2018

| Document brevet cité au rapport de recherche | Date de publication | Membre(s) de la famille de brevet(s) | Date de publication |
|---|---|---|---|
| US 2007084398 A1 | 19-04-2007 | DE 10320133 A1<br>US 2007084398 A1<br>WO 2004100238 A1 | 02-12-2004<br>19-04-2007<br>18-11-2004 |
| US 2016108546 A1 | 21-04-2016 | CN 105229196 A<br>KR 20140137301 A<br>US 2016108546 A1 | 06-01-2016<br>02-12-2014<br>21-04-2016 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20130288464 A1

**Littérature non-brevet citée dans la description**

- **J.-K. CHOI et al.** Growth of Wrinkle-Free Graphene on Texture-Controlled Platinum Films and Thermal-Assisted Transfer of Large Scale Patterned Graphene. *ACS Nano,* 2015, vol. 9 (1), 679-686

- **D.P.NORTON.** Synthesis and properties of epitaxial electronic oxide thin film materials. *Materials Science and Engineering R,* 2004, vol. 43, 139-247